# EUROPEAN PATENT SPECIFICATION

(11) **EP 4 116 725 B1**
(45) Date of publication and mention of the grant of the patent: **27.05.2026**
(21) Application number: 21779529.3
(22) Date of filing: 11.03.2021
(51) Int. Cl.: G01R 31/58, H04B 3/46, H04B 3/54, H04M 11/06

(54) **TRANSMISSION DEVICE AND DATA TRANSMISSION METHOD**
ÜBERTRAGUNGSVORRICHTUNG UND DATENÜBERTRAGUNGSVERFAHREN
DISPOSITIF DE TRANSMISSION ET PROCÉDÉ DE TRANSMISSION DE DONNÉES

(30) Priority: 31.03.2020 CN 202010243582
(43) Date of publication of application: 11.01.2023
(73) Proprietor: Huawei Technologies Co., Ltd., Shenzhen, Guangdong 518129, (CN)
(72) Inventor: LIU, Jin, Shenzhen, Guangdong 518129 (CN); ZHOU, Yang, Shenzhen, Guangdong 518129 (CN)
(74) Representative: Maiwald GmbH
(86) International application number: PCT/CN2021/080232
(87) International publication number: WO 2021/197017

(56) References cited:
- CN-A- 1 120 272
- CN-A- 1 454 414
- CN-A- 106 330 734
- CN-U- 201 821 345
- CN-U- 203 933 671
- DE-A1- 4 328 523
- JP-A- 2008 103 854
- US-A1- 2008 057 866

## Description

This application claims priority to Chinese Patent Application No. 202010243582.1, filed with the China National Intellectual Property Administration on March 31, 2020 and entitled "TRANSMISSION DEVICE AND DATA TRANSMISSION METHOD".

### TECHNICAL FIELD

This application relates to the field of data communications technologies, and in particular, to a transmission device and a data transmission method.

### BACKGROUND

A power line communication modem, is a device that uses a power line communication (power line communication, PLC) technology to perform transmission of data and media signals by using a power line. The power line communication modem may perform data transmission in a single-input single-output (single input single output, SISO) mode, that is, a mode in which a single transmit antenna and a single receive antenna are used to perform data transmission. In the SISO mode, data may be transmitted by using a live wire and a neutral wire in a power grid. To reduce impact of power grid noise and electrical appliance noise in the power grid, based on the SISO mode, the power line communication modem may further transmit data in a SISO+ mode that reduces noise interference, that is, perform data transmission by using the neutral wire and an earth wire in the power grid. In this way, noise generated in a data transmission process can be reduced by using the earth wire. However, if no earth wire is disposed in the power grid, when the power line communication modem performs networking and pairing in a default SISO+ mode, a case in which the power line communication modem needs to switch to the SISO mode for pairing occurs, which causes a low success rate for networking and pairing.
German patent application DE 43 28 523 A1 discloses a device for data transmission in a low-voltage electrical system in which a switch is provided to switch over to a second channel if too much interference occurs on a first channel.

### SUMMARY

The present invention is defined by the attached independent claims. Other preferred embodiments may be found in the dependent claims. The present application discloses a transmission device, comprising: a processor (210), a detection circuit (220), a switch (230), a matching circuit (240), and a transformer (250), wherein a first input terminal of the processor (210) is connected to a first output terminal of the detection circuit (220), a second input terminal and a third input terminal of the processor (210) are respectively connected to a first output terminal and a second output terminal of the matching circuit (240), and an output terminal of the processor (210) is connected to a first terminal of the switch (230); a first output terminal and a second output terminal of the transformer (250) are respectively connected to a first input terminal and a second input terminal of the matching circuit (240), a second input terminal of the transformer (250) is connected to a second terminal of the switch (230), and a second output terminal of the detection circuit (220) is connected to an earth wire; if a first input terminal of the detection circuit (220) is connected to a neutral wire, a second input terminal of the detection circuit (220) is connected to a live wire, a third terminal of the switch (230) is connected to the earth wire or the live wire, and a first input terminal of the transformer (250) is connected to the neutral wire; if the first input terminal of the detection circuit (220) is connected to the live wire, the second input terminal of the detection circuit (220) is connected to the neutral wire, the third terminal of the switch (230) is connected to the earth wire or the neutral wire, and the first input terminal of the transformer (250) is connected to the live wire; the processor (210) is configured to control the detection circuit (220) to detect the earth wire in a power grid and determine, based on a signal output by the detection circuit (220), whether the earth wire is disposed in the power grid; if the earth wire is not disposed in the power grid, controlling, by the processor (210), the switch (230) to be connected to the live wire or the neutral wire in the power grid; or if the earth wire is disposed in the power grid, controlling, by the processor (210), the switch (230) to be connected to the earth wire; and the transformer (250) is configured to convert high-voltage electricity in the power grid into low-voltage electricity, and the matching circuit (240) is configured to match the transmission device with another transmission device connected to the power grid. The present application a data transmission method, wherein the method comprises:detecting, by a detection circuit (220), an earth wire in a power grid;receiving, by a processor (210), a detection signal fed back by the detection circuit (220);determining, by the processor (210) based on the detection signal, whether the power grid comprises the earth wire;controlling, by the processor (210) based on a determining result, a switch (230) to be connected to the earth wire, a live wire, or a neutral wire in the power grid; and performing, by the processor (210), data transmission with a paired transmission device, wherein the paired transmission device is obtained by the processor (210) by controlling a matching circuit (240) to perform matching after the switch (230) is connected to the earth wire, the live wire, or the neutral wire.

### BRIEF DESCRIPTION OF DRAWINGS

To describe technical solutions in embodiments of this application more clearly, the following briefly describes the accompanying drawings for describing embodiments or the conventional technology. It is clear that the accompanying drawings in the following descriptions show some embodiments of this application, and a person of ordinary skill in the field may still derive other drawings from these accompanying drawings without creative efforts.
FIG. 1 is a schematic diagram of a system architecture of a transmission system related to a transmission device according to an embodiment of this application;
FIG. 2 is a block diagram of a structure of a transmission device according to an embodiment of this application;
FIG. 3 is a block diagram of a structure of a detection circuit according to an embodiment of this application;
FIG. 4 is a block diagram of a structure of another detection circuit according to an embodiment of this application;
FIG. 5 is a block diagram of a structure of still another detection circuit according to an embodiment of this application;
FIG. 6 is a block diagram of a structure of yet another detection circuit according to an embodiment of this application;
FIG. 7 is a block diagram of a structure of another transmission device according to an embodiment of this application;
FIG. 8 is a block diagram of a structure of still another transmission device according to an embodiment of this application;
FIG. 9 is a block diagram of a structure of yet another transmission device according to an embodiment of this application; and
FIG. 10 is a schematic flowchart of a data transmission method according to an embodiment of this application.

### DESCRIPTION OF EMBODIMENTS

In the following description, to illustrate rather than limit, specific details such as a particular system structure, and a technology are provided to make a thorough understanding of embodiments of this application. However, a person skilled in the field should know that this application may also be implemented in other embodiments without these specific details. In other cases, detailed descriptions of well-known circuits and methods are omitted, so that this application is described without being disturbed by unnecessary details.

Terms used in the following embodiments are merely for the purpose of describing specific embodiments, but are not intended to limit this application. Terms "one", "the", "the foregoing", and "this" of singular forms used in this specification and the appended claims of this application are also intended to include expressions such as "one or more", unless otherwise specified in the context clearly.

In a related technology, a SISO+ mode is set to a power line communication modem by default. After the power line communication modem is powered on, the power line communication modem may perform pairing with another power line communication modem in a power grid based on a neutral wire and an earth wire required in the SISO+ mode, and determine whether pairing for networking succeeds. If pairing fails, the power line communication modem may continue to wait for yet another power line communication modem in the power grid to access. If pairing still fails after a period of time, it indicates that there is no earth wire in the power grid, and data cannot be transmitted in the SISO+ mode. In this case, the power line communication modem may switch to a SISO mode for networking and pairing, to implement data transmission.

In the foregoing manner, the power line communication modem cannot determine in advance whether the power grid includes the earth wire. As a result, the power line communication modem needs to first perform pairing based on a default SISO+ mode. If pairing fails, it can be determined that no earth wire exists in the power grid, and then the power line communication modem switches to the SISO mode that does not need the earth wire for pairing. Therefore, the networking and pairing success rate of the power line communication modem is low.

However, in embodiments of this application, a detection circuit is disposed in a transmission device (for example, the power line communication modem) to detect whether the power grid includes the earth wire, and a processor in the transmission device controls a switch to be connected to different power lines, so that the transmission device can perform data transmission in different transmission modes. The transmission device first determines whether the power grid includes the earth wire, and then selects a transmission mode based on a determining result, which improves a success rate of pairing the transmission device with the another transmission device for networking.

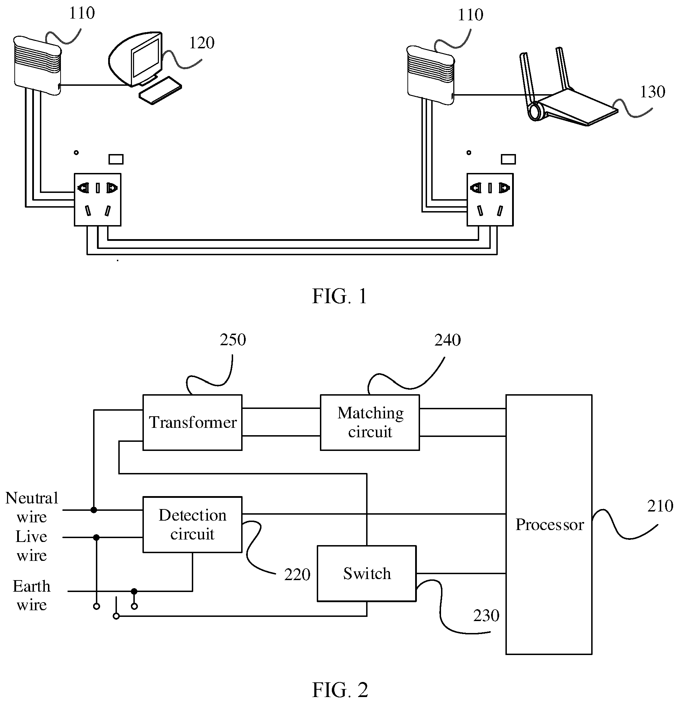

FIG. 1 is a schematic diagram of a system architecture of a transmission system related to a transmission device according to an embodiment of this application. As shown in FIG. 1, the transmission system may include at least two transmission devices 110, at least one terminal device 120, and a router 130.

The router 130 is connected to one of the at least two transmission devices 110 through a link, each terminal device 120 is connected to one transmission device 110, and the transmission devices 110 are connected through a power grid in the transmission system.

In addition, a sum of a quantity of the terminal devices 120 and a quantity of the routers 130 may be greater than or equal to a quantity of the transmission devices 110. For example, if the transmission system includes three terminal devices 120 and one router 130, two, three, or four transmission devices 110 may be disposed. If two transmission devices 110 are disposed, the router 130 may be connected to one transmission device 110, the three terminal devices 120 may all be connected to another transmission device 110. If four transmission devices 110 are disposed, the router 130 and each terminal device 120 may be connected to one transmission device 110.

In addition, the router 130 may be connected to the Internet, and is configured to receive data and send data to the Internet. The transmission devices 110 may be connected to the router 130 through an unshielded twisted pair (unshielded twisted pair, UTP). Similarly, each terminal device 120 may also be connected to the transmission devices 110 through a UTP, and the transmission devices 110 may be connected to each other through the power grid.

It should be noted that, limited by different environments, an earth wire may be disposed in the power grid, or no earth wire may be disposed in the power grid. Therefore, in a process of performing data transmission, the transmission device needs to first detect whether the earth wire exists in the power grid, select, based on a detection result, different transmission modes for pairing with another transmission device and performing data transmission.

In a possible implementation, after the transmission device accesses the power grid, the transmission device is powered on based on electric energy provided by the power grid, and then detects, by using a preset detection circuit, whether the earth wire is disposed in the power grid. If the earth wire is disposed, a SISO+ mode is used for pairing with the another transmission device. However, if no earth wire is deployed in the power grid, a SISO mode is used for pairing. After pairing succeeds, the transmission device may perform data transmission with the another transmission device that is successfully paired in the transmission system.

For example, the transmission device may be a power line communication modem, and may be connected to the power grid in a manner of being plugged into a power socket.

In addition, it should be noted that, in actual application, the terminal device 120 may be a computing device such as a desktop computer, a notebook computer, a palmtop computer, or a cloud server. The terminal device 120 may include but is not limited to: a processor and a memory. A person skilled in the field may understand that this embodiment of this application is merely an example of the terminal device 120, and does not constitute a limitation on the terminal device. The terminal device may include more or fewer components, or combine some components, or different components. For example, the terminal device may further include an input/output device, a network access device, or the like.

FIG. 2 is a block diagram of a structure of a transmission device according to an embodiment of this application. For ease of description, only a part related to this embodiment of this application is shown. As shown in FIG. 2, the transmission device may include a processor 210, a detection circuit 220, a switch 230, a matching circuit 240, and a transformer 250.

A first input terminal of the processor is connected to a first output terminal of the detection circuit, a second input terminal and a third input terminal of the processor are respectively connected to a first output terminal and a second output terminal of the matching circuit, and an output terminal of the processor is connected to a first terminal of the switch. A first output terminal and a second output terminal of the transformer are respectively connected to a first input terminal and a second input terminal of the matching circuit, a second input terminal of the transformer is connected to a second terminal of the switch, and a second output terminal of the detection circuit is connected to an earth wire.

If a first input terminal of the detection circuit is connected to a neutral wire, a second input terminal of the detection circuit is connected to a live wire, a third terminal of the switch is connected to the earth wire or the live wire, and a first input terminal of the transformer is connected to the neutral wire.

If the first input terminal of the detection circuit is connected to the live wire, the second input terminal of the detection circuit is connected to the neutral wire, the third terminal of the switch is connected to the earth wire or the neutral wire, and the first input terminal of the transformer is connected to the live wire.

The processor is configured to control the detection circuit to detect the earth wire in a power grid and determine, based on a signal output by the detection circuit, whether the earth wire is disposed in the power grid. If the earth wire is not disposed in the power grid, the processor may control the switch to be connected to the live wire or the neutral wire in the power grid; or if the earth wire is disposed in the power grid, the processor may control the switch to be connected to the earth wire, to perform pairing and data transmission on the transmission device in different transmission modes based on whether the power grid includes the earth wire.

For example, the processor may be a CPU, or the processor may be another general purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, or a discrete hardware assembly. The general purpose processor may be a microprocessor, or the processor may be any conventional processor or the like.

In addition, the transformer is configured to convert high-voltage electricity in the power grid into low-voltage electricity, and the matching circuit is configured to match the transmission device with another transmission device connected to the power grid.

In a possible implementation, after the transmission device is connected to the power grid, the detection circuit of the transmission device is connected to the power grid, the transmission device is powered on, and then the processor of the transmission device may control the detection circuit to detect the earth wire in the power grid. The detection circuit may detect the earth wire based on an optical coupler in the detection circuit, and output a detection signal. In this case, the processor may receive the detection signal, and determine, based on potential of the detection signal, whether the earth wire exists in the power grid.

The optical coupler is a device that transmits an electrical signal by using light as a medium, and may package a light emitter and a light receptor in a same tube shell. When the electrical signal is added to an input terminal, the light emitter emits light. After being irradiated by the light, the light receptor generates a current, and an output terminal can output the generated current. In this way, "electrical-optical-electrical" conversion is implemented, that is, the optical coupler couples a signal in the input terminal to the output terminal by using the light as the medium. The optical coupler has advantages such as a small size, a long service life, no contact point, strong interference immunity, insulation between the output terminal and the input terminal, and unidirectional signal transmission.

If the earth wire exists in the power grid, the processor may control the switch to be connected to the earth wire, to perform data transmission in a SISO+ mode. If no earth wire is disposed in the power grid, the processor may control the switch to be connected to the live wire, to perform data transmission in a SISO mode.

After a connection is completed, the transformer may perform voltage step-down on the high-voltage electricity in the connected power grid to obtain the low-voltage electricity, so that the processor and the matching circuit may pair the transmission device with the another transmission device connected to the power grid, to determine the another transmission device that pairs with the transmission device, in this way, data transmission can be performed with each paired transmission device.

It should be noted that, in actual application, after the detection circuit detects whether the power grid includes the earth wire, the processor may control the detection circuit to stop detecting the earth wire, to avoid causing interference to transmitted data. For example, a high-level signal may no longer be provided to the optical coupler in the detection circuit, to control the detection circuit to stop detecting the earth wire.

In addition, the third terminal of the switch may be connected to the live wire or the earth wire based on a control signal sent by the processor, so that when the transformer is connected to the neutral wire, the transformer may also be connected to the live wire or the earth wire through the switch. In this case, the neutral wire and the earth wire, or the neutral wire and the live wire are used to perform pairing and data transmission. In FIG. 2, an example in which the third terminal of the switch is connected to the live wire or the earth wire based on the control signal sent by the processor is used for description.

Alternatively, the third terminal of the switch may be connected to the neutral wire or the earth wire based on the control signal sent by the processor, so that when the transformer is connected to the live wire, the transformer may also be connected to the neutral wire or the earth wire through the switch. In this case, pairing and data transmission can be performed by using the live wire and the earth wire, or the neutral wire and the live wire.

For example, the switch may be a relay, and a first terminal of the relay may be connected to the processor, a second terminal may be connected to the transformer, and a third terminal may be connected to the live wire or the earth wire based on the control signal sent by the processor.

Further, in a process of data transmission, the transmission device performs transmission by using the live wire and the earth wire, the neutral wire and the earth wire, or the neutral wire and the live wire, and two input terminals and two output terminals of the matching circuit may also correspond to any two wires in the power grid, that is, the two input terminals of the matching circuit may be separately connected to the neutral wire and the earth wire, or may be separately connected to the live wire and the earth wire, or may be separately connected to the neutral wire and the live wire. The output terminals may be connected to the foregoing wires similarly to the input terminals, and details are not described herein again.

In addition, when the power grid is connected to the matching circuit, in order to prevent the matching circuit from being damaged by the high-voltage electricity of the power grid, the transformer may be used to perform voltage step-down on the high-voltage electricity of the power grid to obtain the low-voltage electricity, and then the matching circuit is connected to the transformer, so that the matching circuit and the processor can perform pairing and data transmission of the transmission device in a low-voltage environment. Similar to the matching circuit, the transformer may also include two input terminals and two output terminals.

For example, refer to FIG. 2. The neutral wire is connected to the first input terminal of the transformer. Correspondingly, the first output terminal corresponding to the first input terminal of the transformer is connected to the first input terminal of the matching circuit, and the first output terminal of the matching circuit is connected to the second input terminal of the processor. The second input terminal of the transformer is connected to the second terminal of the switch, and the processor may control, based on whether the power grid includes the earth wire, the switch to be connected to the earth wire or the live wire, so that the earth wire or the live wire is connected to the second input terminal of the transformer. Similarly, the second output terminal of the transformer is connected to the second input terminal of the matching circuit, and the second output terminal of the matching circuit is connected to the third input terminal of the processor.

In addition, in a process of detecting the earth wire, the detection circuit may detect the earth wire in the power grid based on a detection instruction sent by the processor and a preset optical coupler and another component, to feed back the detection signal to the processor. The processor may determine, based on the detection signal, whether the power grid includes the earth wire, to control the switch to be connected to the earth wire, the neutral wire, or the live wire, and perform data transmission in the SISO+ mode or the SISO mode.

The detection instruction sent by the processor may be an enable signal. The detection instruction is not limited in this embodiment of this application.

It should be noted that, in actual application, the transmission device may further include a memory and a computer program that is stored in the memory and that can be run on at least one processor. When executing the computer program, the processor implements steps in any one of the following data transmission embodiments.

In some embodiments, the memory may be an internal storage unit of the transmission device, for example, a hard disk or memory of the transmission device. In some other embodiments, the memory may also be an external storage device of the transmission device, for example, a plug-connected hard disk, a smart media card (smart media card, SMC), a secure digital (secure digital, SD) card, or a flash card (flash card), or the like that is provided on the transmission device. Further, the memory may include both the internal storage unit and the external storage device. The memory is configured to store an operating system, an application, a BootLoader (BootLoader), data, another program, and the like, for example, program code of the computer program. The memory may be further configured to temporarily store data that has been output or is to be output.

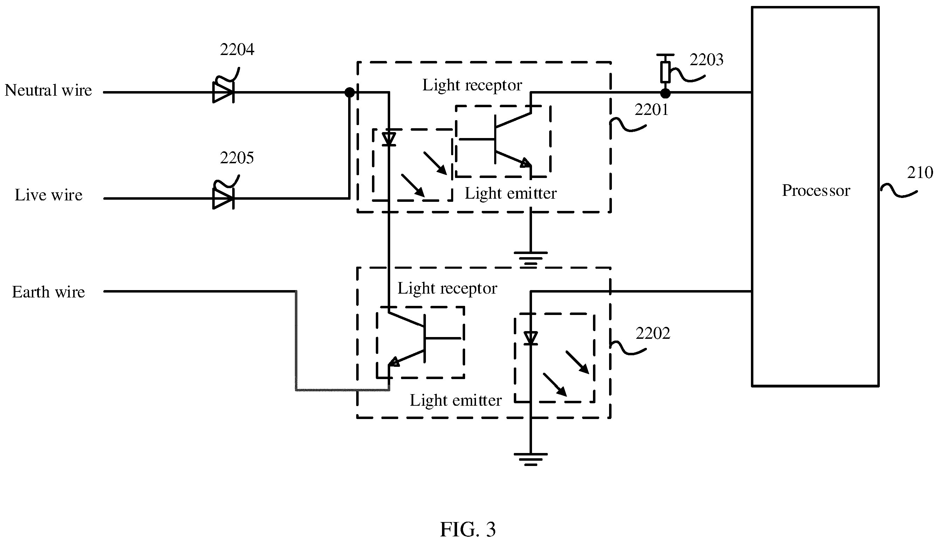

FIG. 3 is a block diagram of a structure of a detection circuit according to an embodiment of this application. As shown in FIG. 3, the detection circuit may include a first optical coupler 2201, a second optical coupler 2202, a pull-up resistor 2203, a first diode 2204, and a second diode 2205.

Both the first optical coupler and the second optical coupler include a light emitter and a light receptor. For example, the light emitter may be a light-emitting diode, and the light receptor may be a phototransistor. The light emitter and the light receptor are not limited in this embodiment of this application.

As shown in FIG. 3, an anode of the first diode is connected to a neutral wire, a cathode of the first diode is connected to a light emitter input terminal of the first optical coupler, an anode of the second diode is connected to a live wire, and a cathode of the second diode is also connected to the light emitter input terminal of the first optical coupler. A light emitter output terminal of the first optical coupler is connected to a light receptor input terminal of the second optical coupler, a light receptor input terminal of the first optical coupler is connected to a first terminal of the pull-up resistor, and a light receptor output terminal of the first optical coupler is connected to a common terminal. The first terminal of the pull-up resistor is connected to a first input terminal of a processor, and a second terminal of the pull-up resistor is connected to high-potential power supply. A light receptor output terminal of the second optical coupler is connected to an earth wire in a power grid, a light emitter input terminal of the second optical coupler is connected to an output terminal of the processor, and a light emitter output terminal of the second optical coupler is connected to the common terminal.

The high-potential power supply may be provided by a built-in power supply of a transmission device, and the common terminal is ground potential for the high-potential power supply. For example, the common terminal may be the ground potential (GND potential) of a circuit board built in the transmission device, and the common terminal and the high-potential power supply are not limited in this embodiment of this application.

Correspondingly, in a process in which the detection circuit detects whether the power grid includes the earth wire, the light emitter of the second optical coupler may receive a detection instruction sent by the processor after the transmission device is connected to the power grid and powered on, and emit light to irradiate the light receptor of the second optical coupler based on the detection instruction, so that the light receptor of the second optical coupler is conducted in combination with the earth wire in the power grid.

If the earth wire exists in the power grid, and the light receptor input terminal of the second optical coupler is connected to the light emitter output terminal of the first optical coupler, a high-potential signal output by the light emitter output terminal of the first optical coupler may be received, and the light receptor output terminal of the second optical coupler is connected to the earth wire, to form a conduction loop. In this case, the light receptor of the second optical coupler is conducted, and the light emitter of the first optical coupler can also be conducted, forming a loop with the neutral wire, the live wire, the light receptor of the second optical coupler, and the earth wire. Therefore, the light emitter of the first optical coupler may emit light to irradiate the light receptor of the first optical coupler.

Correspondingly, the light receptor input terminal of the first optical coupler is connected to the pull-up resistor, and the light receptor output terminal of the first optical coupler is connected to the common terminal. In this case, the first optical coupler may be conducted after being irradiated, the high-potential power supply, the pull-up resistor, the light receptor of the first optical coupler, and the common terminal form a loop. Then, the processor connected to the first terminal of the pull-up resistor may receive a low-level signal of the first terminal of the pull-up resistor, the processor may determine, based on the low-level signal, that the earth wire is disposed in the power grid, control a switch connected to the processor to be connected to the earth wire, and perform pairing and data transmission in a SISO+ mode.

If no earth wire exists in the power grid, the light receptor of the second optical coupler cannot be conducted. In this case, the light emitter of the first optical coupler and the light receptor of the second optical coupler cannot form a loop, the light emitter of the first optical coupler cannot emit light to irradiate the light receptor of the first optical coupler, and the light receptor of the first optical coupler cannot be conducted either. Correspondingly, the processor cannot receive the low-level signal at the first terminal of the pull-up resistor, and the processor may determine that no earth wire exists in the power grid, therefore, the processor may control the switch to be connected to the live wire, and perform pairing and data transmission in a SISO mode.

It should be noted that, after detection of the earth wire is completed, the light emitter of the second optical coupler may receive a stop instruction sent by the processor, so that the light emitter input terminal of the second optical coupler no longer inputs a high-level signal, in this case, the light emitter of the second optical coupler no longer emits light to irradiate the light receptor of the second optical coupler, to stop detecting the earth wire of the power grid, and avoiding impact of the first optical coupler and the second optical coupler on pairing and data transmission of the transmission device.

In addition, in a process in which the transmission device performs pairing and data transmission, the first diode and the second diode that are disposed between the first optical coupler and the live wire and the neutral wire may be used to prevent backflow of an electrical signal that is transmitted on the live wire and/or the neutral wire and that includes data, and prevent short circuit of the neutral wire and the live wire.

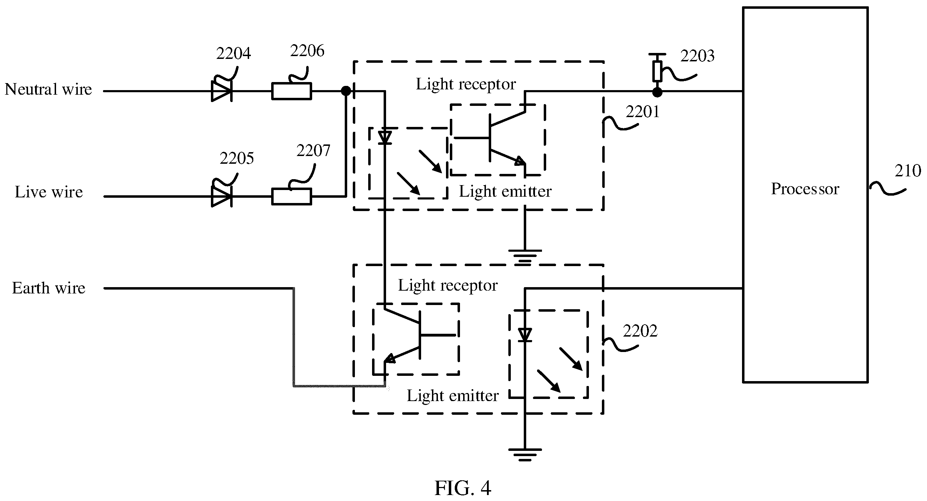

In addition, refer to FIG. 4. Based on the detection circuit shown in FIG. 3, FIG. 4 is a block diagram of a structure of another detection circuit according to an embodiment of this application. As shown in FIG. 4, the detection circuit may further include a first current-limiting resistor 2206 and a second current-limiting resistor 2207.

The first current-limiting resistor is disposed between the first diode and the light emitter input terminal of the first optical coupler, and the second current-limiting resistor is disposed between the second diode and the light emitter input terminal of the first optical coupler.

Because the power grid outputs high-voltage electricity, to avoid damage to the detection circuit caused by an excessively high voltage or current, a current-limiting resistor may be disposed between the first optical coupler and the live wire and the neutral wire, to prevent an excessively high current flowing through the first optical coupler from damaging the first optical coupler and another circuit component.

For example, both the first current-limiting resistor and the second current-limiting resistor may be set to resistors of a kilohm level. Certainly, the first current-limiting resistor and the second current-limiting resistor may also be set to resistors of another resistance value. This is not limited in this embodiment of this application.

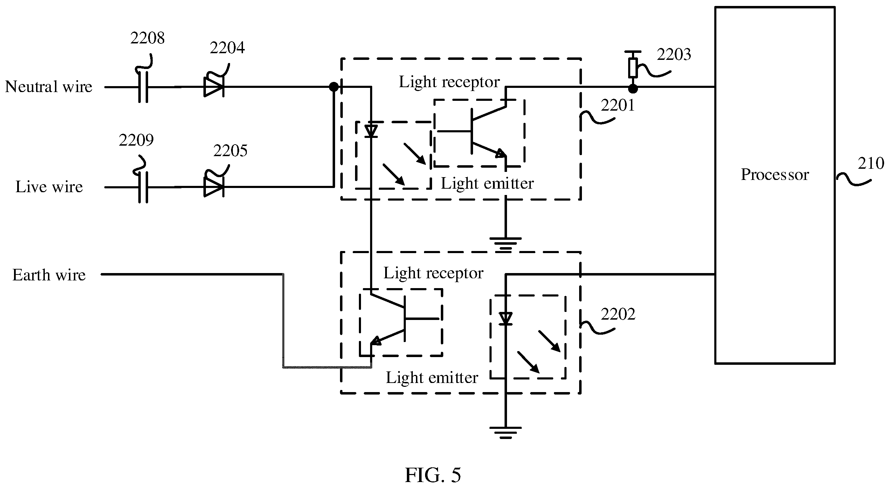

Further, refer to FIG. 5. Based on the detection circuit shown in FIG. 3, FIG. 5 is block diagram of a structure of still another detection circuit according to an embodiment of this application. As shown in FIG. 5, the detection circuit may further include: a first safety capacitor 2208 and a second safety capacitor 2209.

The first safety capacitor is connected in series between the neutral wire and the anode of the first diode, so that the safety capacitor is disposed between the neutral wire and the earth wire, and a safety accident caused by an electrical shock after a capacitor failure can be avoided. Similarly, the second safety capacitor may be connected in series between the live wire and the anode of the second diode.

In addition, both the first safety capacitor and the second safety capacitor may be Class Y capacitors, and in a case in which the electrical shock is avoided, common-mode interference occurring in a data transmission process may be further suppressed, to improve data transmission quality.

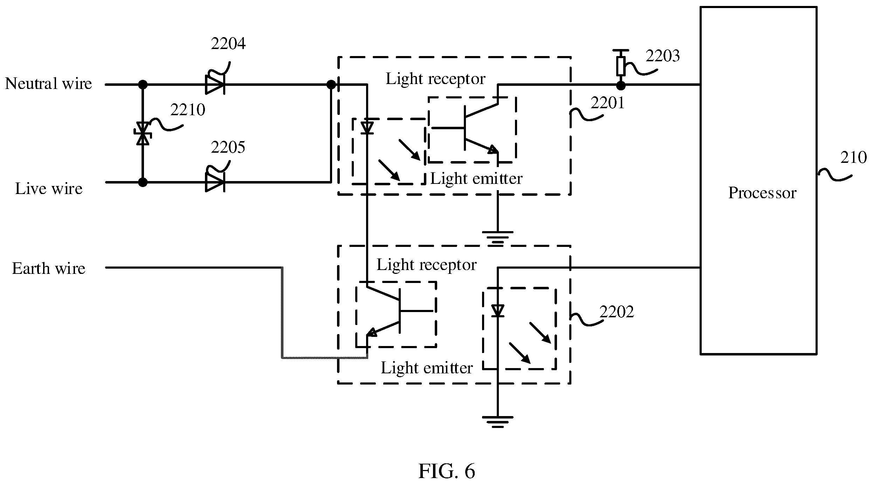

It should be noted that, to avoid damage to the transmission device caused by an electrical surge phenomenon occurring at the moment of power-on of the transmission device, a protection circuit may be disposed between the live wire and the neutral wire. Refer to FIG. 6. Based on the detection circuit shown in FIG. 3, FIG. 6 is a block diagram of a structure of still another detection circuit according to an embodiment of this application. As shown in FIG. 6, the detection circuit may further include a protection circuit 2210, where the protection circuit is connected in series between the live wire and the neutral wire.

For example, the protection circuit may include a transient suppression diode, and the transient suppression diode may include a unipolar transient suppression diode and a bipolar transient suppression diode. The unipolar transient suppression diode is applied to a direct current environment, and the bipolar transient suppression diode is applied to an alternating current environment, and when the transmission device is used in the alternating current environment of the power grid, the bipolar transient suppression diode can be used to form the protection circuit.

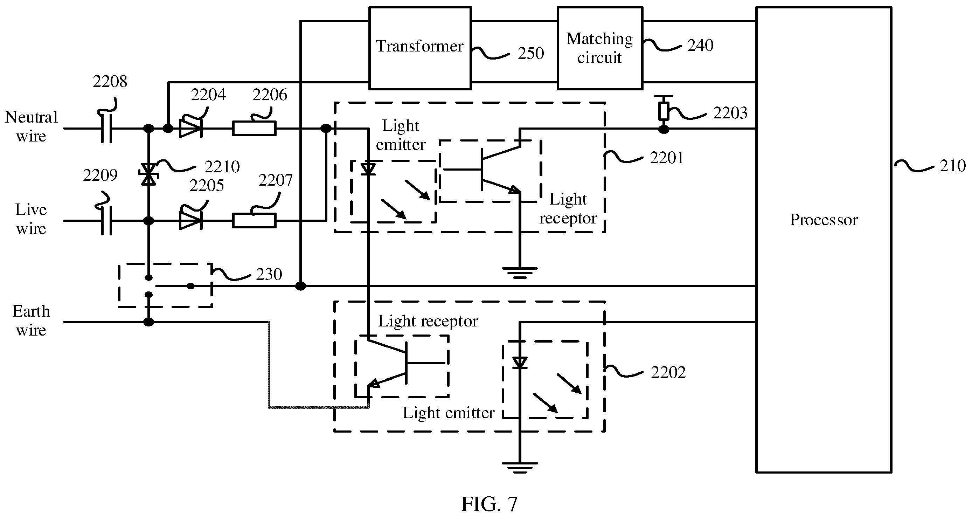

Refer to FIG. 7. Based on the detection circuits respectively shown in FIG. 3 to FIG. 6, FIG. 7 is a block diagram of a structure of another transmission device according to an embodiment of this application. As shown in FIG. 7, the detection circuit of the transmission device includes the components shown in FIG. 3 to FIG. 6.

After the transmission device is connected to the power grid, the transmission device is powered on, and the processor may send the detection instruction of the high-level signal to the light emitter of the second optical coupler. The light emitter of the second optical coupler may irradiate, based on the high-level signal, the light receptor of the second optical coupler. If the earth wire is disposed in the power grid, the light receptor of the second optical coupler, in a case in which the light receptor of the second optical coupler receives the high-level signal output by the light emitter of the first optical coupler, may form a loop with the light emitter of the first optical coupler and the earth wire, so that the light receptor of the second optical coupler and the light emitter of the first optical coupler are conducted. Correspondingly, the light receptor of the first optical coupler is irradiated by the light emitter of the first optical coupler, and may form a loop with the pull-up resistor. If the first terminal of the pull-up resistor is at low potential, the processor may receive a low-potential signal, to determine that the earth wire is disposed in the power grid, control the switch to be connected to the earth wire in the power grid, and perform pairing and data transmission on the transmission device based on the earth wire and the neutral wire.

If no earth wire is disposed in the power grid, after the detection is performed in the foregoing manner, the processor may control the switch to be connected to the live wire, to perform pairing and data transmission on the transmission device by using the live wire and the earth wire.

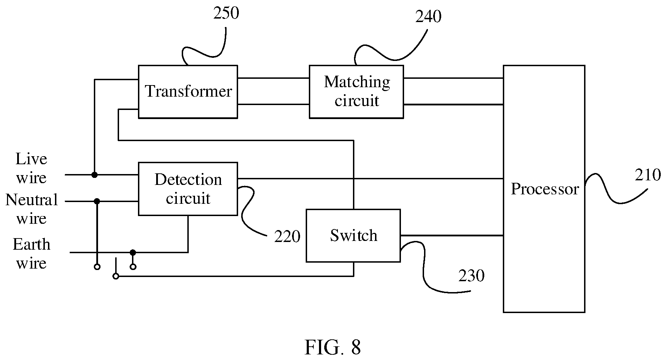

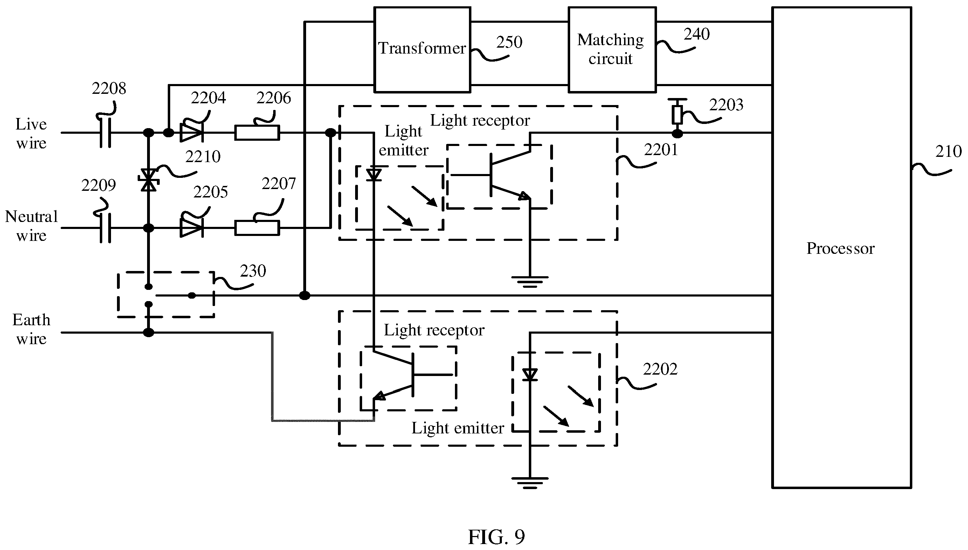

It should be noted that this embodiment of this application is described merely by using the SISO+ mode in which data transmission is performed by using the neutral wire and the earth wire as an example. However, in actual application, the SISO+ mode in which data transmission is performed by using the live wire and the earth wire may also be used. Refer to FIG. 8 and FIG. 9. If data transmission is performed by using the live wire and the earth wire, the transmission device may be connected through a circuit shown in FIG. 8, that is, the first input terminal of the detection circuit may be connected to the live wire, the second input terminal of the detection circuit may be connected to the neutral wire, the first output terminal of the detection circuit is connected to the first input terminal of a processor, and the second output terminal of the detection circuit may be connected to the earth wire. The first input terminal of the transformer is connected to the live wire, and the first output terminal and the second output terminal of the transformer are respectively connected to the first input terminal and the second input terminal of the matching circuit. The first terminal of the switch is connected to the output terminal of the processor, the second terminal of the switch is connected to the second input terminal of the transformer, and the third terminal of the switch may be connected to the earth wire or the neutral wire. The second input terminal and the third input terminal of the processor are respectively connected to the first output terminal and the second output terminal of the matching circuit.

Compared with the circuit shown in FIG. 8. a circuit shown in FIG. 9 shows components included in the detection circuit shown in FIG. 8. The processor controls the switch, so that the switch may be connected to the earth wire or the neutral wire, and the live wire may be connected to the transformer through the first safety capacitor. In this way, the live wire is always connected to the transformer, and the switch may be connected to the earth wire or the neutral wire based on whether the power grid includes the earth wire, to perform data transmission by using the live wire and the earth wire in the SISO+ mode, or perform data transmission by using the live wire and the neutral wire in the SISO mode, which is not described herein again.

In conclusion, the transmission device provided in embodiments of this application detects the earth wire in the power grid by using the detection circuit, and the processor may receive the detection signal fed back by the detection circuit, determine, based on the detection signal, whether the power grid includes the earth wire, and then, based on the determining result, control the switch to be connected to the earth wire, the live wire, or the neutral wire in the power grid, so that the transmission device may be connected to different power lines, to perform data transmission in different transmission modes. Before performing pairing and networking, the transmission device determines whether the power grid to which the transmission device is connected includes the earth wire, and controls, based on the determining result, the switch of the transmission device to be connected to the earth wire, the live wire, or the neutral wire, to perform pairing and networking with the another transmission device in the power grid in different transmission modes. In this way, after networking, the transmission device can perform data transmission with a paired transmission device, which improves a success rate of pairing and networking performed by the transmission device, reduces needs of the transmission device to switch a transmission mode to perform pairing and networking again, and improves efficiency of pairing and networking performed by the transmission device.

In addition, after receiving the detection instruction sent by the processor, the light emitters and the light receptors of the first optical coupler and the second optical coupler in the detection circuit may determine, based on a principle that the light emitters, the light receptors, and the circuit form a loop and conduction and light emitting of these components, whether the earth wire is disposed in the power grid. A method for detecting whether the earth wire is disposed in the power grid is provided, which improves efficiency of detecting whether the power grid includes the earth wire.

In addition, the first diode and the second diode are disposed in the detection circuit, so that backflow of an electrical signal that includes data and that is transmitted on the neutral wire and/or the live wire can be prevented, and short circuit between the live wire and the neutral wire can be prevented. The current-limiting resistors are disposed in the detection circuit, so that damage to the detection circuit caused by an excessively high current flowing through the detection circuit can be prevented. The first safety capacitor and the second safety capacitor are disposed in the detection circuit, so that an electrical shock phenomenon can be prevented after the capacitor failure. Disposing a protection circuit in the detection circuit can prevent damage to the transmission device caused by the electrical surge phenomenon occurring at the moment when the transmission device is powered on, which improves security of the detection circuit and the transmission device.

It should be noted that, after it is determined whether the power grid includes the earth wire, the processor controls the detection circuit to stop detecting the earth wire in the power grid, to prevent the detection circuit from continuously detecting the earth wire in the power grid and from affecting transmitted data, which improves data transmission quality.

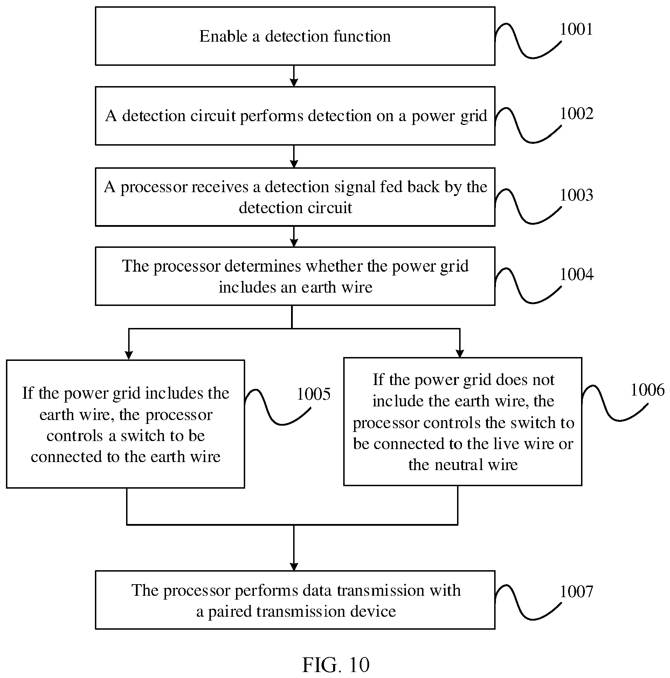

FIG. 10 is a schematic flowchart of a data transmission method according to an embodiment of this application. As an example instead of a limitation, the method may be applied to the foregoing transmission device. Refer to FIG. 10. The method includes the following steps.

Step 1001: Enable a detection function.

In a local area network, a transmission device may use different transmission modes based on wire conditions of a power grid, to pair with another successfully paired transmission device and perform data transmission. If the power grid includes an earth wire, the transmission device may perform data transmission in a SISO+ mode with less interference. If the power grid does not include the earth wire, the transmission device needs to perform data transmission in a SISO mode.

Therefore, to determine a transmission mode used for data transmission, after being connected to the power grid, the transmission device may first enable the detection function, to detect whether the power grid includes the earth wire, and select different transmission modes to perform pairing and data transmission for the transmission device.

In a possible implementation, if the transmission device is connected to the power grid, the power grid may supply electric energy to the transmission device, and the transmission device may complete a power-on process. After the power-on process, the transmission device may enable the detection function to detect whether the power grid includes the earth wire, so that in a subsequent step, the transmission device may perform pairing with another transmission device in the SISO mode or the SISO+ mode based on a detection result, and perform data transmission.

Optionally, a processor of the transmission device may send a detection instruction to a detection circuit of the transmission device, so that the detection circuit may detect the earth wire in the power grid based on the detection instruction, to determine whether the earth wire is disposed in the power grid.

For example, the detection circuit may include a second optical coupler described in the foregoing embodiments, and the second optical coupler may include a light emitter and a light receptor. In this case, the processor may send a high-level signal as the detection instruction to the light emitter of the second optical coupler, so that a voltage difference between an input terminal and an output terminal of the light emitter of the second optical coupler is greater than a voltage threshold of the light emitter. Therefore, the light emitter may be conducted and emit light, and irradiate the light receptor of the second optical coupler, so that in the subsequent step, whether the power grid includes the earth wire may be detected based on the light receptor of the second optical coupler and another component of the detection circuit.

It should be noted that, in actual application, the transmission device is usually used in pairs. For example, one transmission device may be connected to a router, another transmission device may be connected to a terminal device, and the terminal device may receive, by using the transmission device, data sent by the router, or may further forward the data sent by the terminal device to the Internet by using the transmission device and the router.

Step 1002: The detection circuit performs detection on the power grid.

After being powered on, the transmission device may detect whether the power grid includes the earth wire, and the detection circuit of the transmission device may control, based on a level signal sent by the processor of the transmission device, each component in the detection circuit to be conducted, generate a detection signal including the detection result, and feed back the detection signal to the processor.

Corresponding to detection instruction sending of the processor in step 1001, after receiving the detection instruction sent by the processor, the detection circuit may detect, based on the detection instruction and by using a first optical coupler and the second optical coupler in the detection circuit, whether the earth wire is disposed in the power grid, and feed back, to the processor by using a pull-up resistor of the detection circuit, the detection signal including the detection result.

Optionally, the light emitter of the second optical coupler in the detection circuit may be conducted and emit light based on the detection instruction, so that the emitted light irradiates the light receptor of the second optical coupler. If the light receptor of the second optical coupler is connected to the earth wire of the power grid, the light receptor of the second optical coupler and a light emitter of the first optical coupler are conducted, so that the light emitter of the first optical coupler emits light to irradiate a light receptor of the first optical coupler, the light receptor of the first optical coupler is conducted, and potential of a first terminal of the pull-up resistor in the detection circuit decreases.

For example, the light emitter of the second optical coupler in the detection circuit may receive the detection instruction sent by the processor, where the detection instruction may be the high-level signal, and the light emitter of the second optical coupler may be conducted and emit light based on a potential difference formed by the high-level signal, and irradiate the light receptor of the second optical coupler.

If the earth wire exists in the power grid, a light receptor output terminal of the second optical coupler may be connected to the earth wire, a light receptor input terminal of the second optical coupler is connected to a light emitter output terminal of the first optical coupler, and a light emitter input terminal of the first optical coupler is connected to a live wire and a neutral wire of the power grid. In this case, the light receptor input terminal of the second optical coupler is at a high level, and, in a case in which the light receptor of the second optical coupler is connected to the earth wire, the light receptor of the second optical coupler may be conducted, so that the light emitter of the first optical coupler is also conducted to emit light, to irradiate the light receptor of the first optical coupler, and the light receptor of the first optical coupler is conducted under irradiation.

Correspondingly, for the pull-up resistor connected to a light receptor input terminal of the first optical coupler, when the light receptor is not conducted, the potential of the first terminal of the pull-up resistor is at a high level. After the light receptor of the first optical coupler is conducted, because impedance of the light receptor is extremely low, the potential of the first terminal of the pull-up resistor jumps from the high level to a low level.

However, if there is no earth wire in the power grid, the light receptor of the second optical coupler is not conducted, the light emitter of the first optical coupler is not conducted and does not emit light either, the light receptor of the first optical coupler is not conducted either, and the potential of the first terminal of the pull-up resistor does not change either.

Step 1003: The processor receives the detection signal fed back by the detection circuit.

If the processor of the transmission device is connected to the first terminal of the pull-up resistor in the detection circuit, the processor may detect a potential signal of the first terminal of the pull-up resistor, to use the potential signal as the detection signal fed back by the detection circuit.

It should be noted that, after determining whether the power grid includes the earth wire, the processor may send a stop instruction to the detection circuit, so that the detection circuit stops detecting whether the power grid includes the earth wire, which avoids impact on transmitted data. For example, the processor may stop sending the high-level signal to the detection circuit, but send a low-level signal, and the light emitter of the second optical coupler in the detection circuit is no longer conducted and no longer emits light, so that detection of the earth wire in the power grid may be stopped.

Step 1004: The processor determines whether the power grid includes the earth wire.

The processor may detect the potential signal of the first terminal of the pull-up resistor, and determine, based on the high or low level of the potential signal, whether the power grid includes the earth wire. If the power grid includes the earth wire, step 1005 may be performed to perform pairing and data transmission in the SISO+ mode. However, if the power grid does not include the earth wire, step 1006 may be performed to perform pairing and data transmission in the SISO mode.

For example, if the processor detects that the potential of the first terminal of the pull-up resistor jumps to the low level, it may be determined that the earth wire is disposed in the power grid. If the processor does not detect that the potential of the first terminal of the pull-up resistor changes, it indicates that the light receptor of the first optical coupler is not conducted, and it may be determined that no earth wire is disposed in the power grid.

Step 1005: If the power grid includes the earth wire, the processor controls a switch to be connected to the earth wire.

If the processor determines that the power grid includes the earth wire, the processor may be paired with the another transmission device in the SISO+ mode, and perform data transmission with the another transmission device in the SISO+ mode. Correspondingly, the processor may send a control signal to the switch, and the switch may be connected to the earth wire of the power grid based on the control signal.

Step 1006: If the power grid does not include the earth wire, the processor controls the switch to be connected to the live wire or the neutral wire.

If the power grid does not include the earth wire, it indicates that the transmission device cannot use the SISO+ mode to perform paired transmission, and needs to use the SISO mode to perform paired transmission. In this case, the processor may control the switch to be connected to the live wire or the neutral wire, to perform pairing by using the live wire and the neutral wire.

For example, the switch is a relay, and is further connected to the processor while being connected to a transformer. After receiving the control signal sent by the processor, the switch may control, based on a high or low level of the control signal, the relay to be connected to the live wire or the neutral wire, to perform the paired transmission in the SISO mode.

It should be noted that, in actual application, the switch may be set between the live wire and the earth wire, and the neutral wire is connected to the transformer. Alternatively, the switch may be disposed between the neutral wire and the earth wire, and the live wire is connected to the transformer. An example in which the switch is disposed between the live wire and the earth wire is merely used for description in this embodiment of this application. A manner of disposing the switch is not limited in this embodiment of this application.

Step 1007: The processor performs data transmission with a paired transmission device.

The paired transmission device is determined by the processor by controlling a matching circuit to perform matching after the switch is connected to the earth wire, the live wire, or the neutral wire.

After determining the transmission mode, the transmission device may perform pairing and networking with the another transmission device in a selected mode, and after pairing succeeds, may perform data transmission with the another successfully paired transmission device, to implement data transmission by using a wire in the power grid.

For example, after both a first transmission device and a second transmission device are plugged into a power socket, it may be considered that both the first transmission device and the second transmission device are connected to the power grid. In this case, the first transmission device and the second transmission device may determine the transmission mode in the foregoing manner, and perform pairing based on a determined transmission mode. If the first transmission device detects the second transmission device, the first transmission device may perform pairing with the second transmission device based on a preset configuration file, to complete pairing and networking of the transmission devices.

If the first transmission device is connected to the router, and the second transmission device is connected to a desktop computer, the desktop computer may perform data transmission with the router by using the first transmission device and the second transmission device, may receive Internet data forwarded by the router, or may forward, to the Internet by using the router, data sent by the desktop computer.

In conclusion, the data transmission method provided in embodiments of this application detects the earth wire in the power grid by using the detection circuit, and the processor may receive the detection signal fed back by the detection circuit, determine, based on the detection signal, whether the power grid includes the earth wire, and then control, based on a determining result, the switch to be connected to the earth wire, the live wire, or the neutral wire in the power grid, so that the transmission device may be connected to different power lines, to perform data transmission in different transmission modes. Before performing pairing and networking, the transmission device determines whether the power grid to which the transmission device is connected includes the earth wire, and controls, based on the determining result, the switch of the transmission device to be connected to the earth wire, the live wire, or the neutral wire, to perform pairing and networking with another transmission device in the power grid in different transmission modes. In this way, after networking, the transmission device can perform data transmission with a paired transmission device, which improves a success rate of pairing and networking performed by the transmission device, reduces needs of the transmission device to switch a transmission mode to perform pairing and networking again, and improves efficiency of pairing and networking performed by the transmission device.

In addition, after receiving the detection instruction sent by the processor, the light emitters and the light receptors of the first optical coupler and the second optical coupler in the detection circuit may determine, based on a principle that the light emitters, the light receptors, and the circuit form a loop and conduction and light emitting of these components, whether the earth wire is disposed in the power grid. A method for detecting whether the earth wire is disposed in the power grid is provided, which improves efficiency of detecting whether the power grid includes the earth wire.

In addition, after it is determined whether the power grid includes the earth wire, the processor controls the detection circuit to stop detecting the earth wire in the power grid, to prevent the detection circuit from continuously detecting the earth wire in the power grid and from affecting transmitted data, which improves data transmission quality.

In the foregoing embodiments, the description of each embodiment has respective focuses. For a part that is not described in detail or recorded in an embodiment, refer to related descriptions in other embodiments.

A person of ordinary skill in the field may be aware that, circuit modules and algorithm steps in the examples described with reference to embodiments disclosed in this specification can be implemented by electronic hardware or a combination of computer software and electronic hardware. Whether these functions are performed by hardware or software depends on particular applications and design constraints of technical solutions. A person skilled in the art may use different methods to implement the described functions for each particular application, but it should not be considered that the implementation goes beyond the scope of this application.

In embodiments provided in this application, it should be understood that the disclosed transmission device and method may be implemented in other manners. For example, the described embodiments are merely examples. For example, division into the circuit modules in the transmission device is merely logical function division and may be other division in an actual implementation. For example, a plurality of components may be combined or integrated into another circuit module, or some features may be ignored or not performed. In addition, the displayed or discussed mutual couplings or direct couplings or communication connections may be implemented through some interfaces. The indirect couplings or communication connections between the apparatuses or units may be implemented in electronic or other forms.

## Claims

1. A transmission device, comprising: a processor (210), a detection circuit (220), a switch (230), a matching circuit (240), and a transformer (250), wherein
a first input terminal of the processor (210) is connected to a first output terminal of the detection circuit (220), a second input terminal and a third input terminal of the processor (210) are respectively connected to a first output terminal and a second output terminal of the matching circuit (240), and an output terminal of the processor (210) is connected to a first terminal of the switch (230);
a first output terminal and a second output terminal of the transformer (250) are respectively connected to a first input terminal and a second input terminal of the matching circuit (240), a second input terminal of the transformer (250) is connected to a second terminal of the switch (230), and a second output terminal of the detection circuit (220) is connected to an earth wire;
if a first input terminal of the detection circuit (220) is connected to a neutral wire, a second input terminal of the detection circuit (220) is connected to a live wire, a third terminal of the switch (230) is connected to the earth wire or the live wire, and a first input terminal of the transformer (250) is connected to the neutral wire;
if the first input terminal of the detection circuit (220) is connected to the live wire, the second input terminal of the detection circuit (220) is connected to the neutral wire, the third terminal of the switch (230) is connected to the earth wire or the neutral wire, and the first input terminal of the transformer (250) is connected to the live wire;
the processor (210) is configured to control the detection circuit (220) to detect the earth wire in a power grid and determine, based on a signal output by the detection circuit (220), whether the earth wire is disposed in the power grid; if the earth wire is not disposed in the power grid, controlling, by the processor (210), the switch (230) to be connected to the live wire or the neutral wire in the power grid; or if the earth wire is disposed in the power grid, controlling, by the processor (210), the switch (230) to be connected to the earth wire; and
the transformer (250) is configured to convert high-voltage electricity in the power grid into low-voltage electricity, and the matching circuit (240) is configured to match the transmission device with another transmission device connected to the power grid.

2. The transmission device according to claim 1, wherein the detection circuit (220) comprises: a first optical coupler, a second optical coupler, a pull-up resistor, a first diode, and a second diode, wherein both the first optical coupler and the second optical coupler comprise a light emitter and a light receptor; wherein
an anode of the first diode is connected to the neutral wire, and a cathode of the first diode is connected to a light emitter input terminal of the first optical coupler;
an anode of the second diode is connected to the live wire, and a cathode of the second diode is connected to the light emitter input terminal of the first optical coupler;
a light emitter output terminal of the first optical coupler is connected to a light receptor input terminal of the second optical coupler, a light receptor input terminal of the first optical coupler is connected to a first terminal of the pull-up resistor, and a light receptor output terminal of the first optical coupler is connected to a common terminal;
the first terminal of the pull-up resistor is connected to the first input terminal of the processor (210), and a second terminal of the pull-up resistor is connected to high-potential power supply; and
a light receptor output terminal of the second optical coupler is connected to the earth wire in the power grid, a light emitter input terminal of the second optical coupler is connected to the output terminal of the processor (210), and a light emitter output terminal of the second optical coupler is connected to the common terminal.

3. The transmission device according to claim 2, wherein the detection circuit (220) further comprises: a first current-limiting resistor and a second current-limiting resistor; wherein
the first current-limiting resistor is disposed between the first diode and the light emitter input terminal of the first optical coupler, and the second current-limiting resistor is disposed between the second diode and the light emitter input terminal of the first optical coupler.

4. The transmission device according to claim 2, wherein the detection circuit (220) further comprises: a first safety capacitor and a second safety capacitor; wherein
the first safety capacitor is connected in series between the neutral wire and the anode of the first diode, and the second safety capacitor is connected in series between the live wire and the anode of the second diode.

5. The transmission device according to claim 2, wherein the detection circuit (220) further comprises a protection circuit, and the protection circuit is connected in series between the live wire and the neutral wire; wherein
the protection circuit is formed by a transient suppression diode.

6. A data transmission method, wherein the method comprises:
detecting, by a detection circuit (220), an earth wire in a power grid;
receiving, by a processor (210), a detection signal fed back by the detection circuit (220);
determining, by the processor (210) based on the detection signal, whether the power grid comprises the earth wire;
controlling, by the processor (210) based on a determining result, a switch (230) to be connected to the earth wire, a live wire, or a neutral wire in the power grid; and
performing, by the processor (210), data transmission with a paired transmission device, wherein the paired transmission device is obtained by the processor (210) by controlling a matching circuit (240) to perform matching after the switch (230) is connected to the earth wire, the live wire, or the neutral wire.

7. The data transmission method according to claim 6, wherein before the detecting, by a detection circuit (220), an earth wire in a power grid, the method further comprises:
sending, by the processor (210), a detection instruction to the detection circuit (220) of the transmission device, so that the detection circuit (220) detects the earth wire in the power grid based on the detection instruction to determine whether the earth wire is disposed in the power grid.

8. The data transmission method according to claim 7, wherein the detecting, by a detection circuit (220), an earth wire in a power grid comprises:
conducting and emitting light, by a light emitter of a second optical coupler in the detection circuit (220), based on the detection instruction, so that the emitted light irradiates a light receptor of the second optical coupler; and
if the light receptor of the second optical coupler is connected to the earth wire of the power grid, the light receptor of the second optical coupler and a light emitter of a first optical coupler are conducted, so that the light emitter of the first optical coupler emits light to irradiate a light receptor of the first optical coupler, the light receptor of the first optical coupler is conducted, and potential of a first terminal of a pull-up resistor in the detection circuit (220) decreases.

9. The data transmission method according to any one of claims 6 to 8, wherein the controlling, by the processor (210) based on a determining result, a switch (230) to be connected to the earth wire, a live wire, or a neutral wire in the power grid comprises:
if the power grid comprises the earth wire, controlling, by the processor (210), the switch (230) to be connected to the earth wire; or
if the power grid does not comprise the earth wire, controlling, by the processor (210), the switch (230) to be connected to the live wire or the neutral wire.

## Patentansprüche

1. Übertragungsvorrichtung, umfassend: einen Prozessor (210), eine Detektionsschaltung (220), einen Schalter (230), eine Anpassungsschaltung (240) und einen Transformator (250), wobei ein erster Eingangsanschluss des Prozessors (210) mit einem ersten Ausgangsanschluss der Detektionsschaltung (220) verbunden ist, ein zweiter Eingangsanschluss und ein dritter Eingangsanschluss des Prozessors (210) mit einem ersten Ausgangsanschluss beziehungsweise einem zweiten Ausgangsanschluss der Anpassungsschaltung (240) verbunden sind und ein Ausgangsanschluss des Prozessors (210) mit einem ersten Anschluss des Schalters (230) verbunden ist;
ein erster Ausgangsanschluss und ein zweiter Ausgangsanschluss des Transformators (250) mit einem ersten Eingangsanschluss beziehungsweise einem zweiten Eingangsanschluss der Anpassungsschaltung (240) verbunden sind, ein zweiter Eingangsanschluss des Transformators (250) mit einem zweiten Anschluss des Schalters (230) verbunden ist und ein zweiter Ausgangsanschluss der Detektionsschaltung (220) mit einem Erdungsleiter verbunden ist;
falls ein erster Eingangsanschluss der Detektionsschaltung (220) mit einem Neutralleiter verbunden ist, ein zweiter Eingangsanschluss der Detektionsschaltung (220) mit einem stromführenden Leiter verbunden ist, ein dritter Anschluss des Schalters (230) mit dem Erdungsleiter oder dem stromführenden Leiter verbunden ist und ein erster Eingangsanschluss des Transformators (250) mit dem Neutralleiter verbunden ist;
falls der erste Eingangsanschluss der Detektionsschaltung (220) mit dem stromführenden Leiter verbunden ist, der zweite Eingangsanschluss der Detektionsschaltung (220) mit dem Neutralleiter verbunden ist, der dritte Anschluss des Schalters (230) mit dem Erdungsleiter oder dem Neutralleiter verbunden ist und der erste Eingangsanschluss des Transformators (250) mit dem stromführenden Leiter verbunden ist;
der Prozessor (210) dazu konfiguriert ist, die Detektionsschaltung (220) zu steuern, um den Erdungsleiter in einem Leistungsnetz zu detektieren und basierend auf einem Signal, das durch die Detektionsschaltung (220) ausgegeben wird, zu bestimmen, ob der Erdungsleiter in dem Leistungsnetz angeordnet ist; falls der Erdungsleiter nicht in dem Leistungsnetz angeordnet ist, Steuern, durch den Prozessor (210), des Schalters (230), um mit dem stromführenden Leiter oder dem Neutralleiter in dem Leistungsnetz verbunden zu sein; oder, falls der Erdungsleiter in dem Leistungsnetz angeordnet ist, Steuern, durch den Prozessor (210), des Schalters (230), um mit dem Erdungsleiter verbunden zu sein; und
der Transformator (250) dazu konfiguriert ist, eine Hochspannungselektrizität in dem Leistungsnetz in eine Niederspannungselektrizität umzuwandeln, und die Anpassungsschaltung (240) dazu konfiguriert ist, die Übertragungsvorrichtung an eine andere Übertragungsvorrichtung anzupassen, die mit dem Leistungsnetz verbunden ist.

2. Übertragungsvorrichtung nach Anspruch 1, wobei die Detektionsschaltung (220) Folgendes umfasst: einen ersten optischen Koppler, einen zweiten optischen Koppler, einen Pull-up-Widerstand, eine erste Diode und eine zweite Diode, wobei sowohl der erste optische Koppler als auch der zweite optische Koppler einen Lichtemitter und einen Lichtempfänger umfassen; wobei eine Anode der ersten Diode mit dem Neutralleiter verbunden ist und eine Kathode der ersten Diode mit einem Lichtemitter-Eingangsanschluss des ersten optischen Kopplers verbunden ist; eine Anode der zweiten Diode mit dem stromführenden Leiter verbunden ist und eine Kathode der zweiten Diode mit dem Lichtemitter-Eingangsanschluss des ersten optischen Kopplers verbunden ist;
ein Lichtemitter-Ausgangsanschluss des ersten optischen Kopplers mit einem Lichtempfänger-Eingangsanschluss des zweiten optischen Kopplers verbunden ist, ein Lichtempfänger-Eingangsanschluss des ersten optischen Kopplers mit einem ersten Anschluss des Pull-up-Widerstands verbunden ist und ein Lichtempfänger-Ausgangsanschluss des ersten optischen Kopplers mit einem gemeinsamen Anschluss verbunden ist;
der erste Anschluss des Pull-up-Widerstands mit dem ersten Eingangsanschluss des Prozessors (210) verbunden ist und ein zweiter Anschluss des Pull-up-Widerstands mit einer Hochpotentialleistungsversorgung verbunden ist; und
ein Lichtempfänger-Ausgangsanschluss des zweiten optischen Kopplers mit dem Erdungsleiter in dem Leistungsnetz verbunden ist, ein Lichtemitter-Eingangsanschluss des zweiten optischen Kopplers mit dem Ausgangsanschluss des Prozessors (210) verbunden ist und ein Lichtemitter-Ausgangsanschluss des zweiten optischen Kopplers mit dem gemeinsamen Anschluss verbunden ist.

3. Übertragungsvorrichtung nach Anspruch 2, wobei die Detektionsschaltung (220) ferner Folgendes umfasst: einen ersten Strombegrenzungswiderstand und einen zweiten Strombegrenzungswiderstand; wobei
der erste Strombegrenzungswiderstand zwischen der ersten Diode und dem Lichtemitter-Eingangsanschluss des ersten optischen Kopplers angeordnet ist und der zweite Strombegrenzungswiderstand zwischen der zweiten Diode und dem Lichtemitter-Eingangsanschluss des ersten optischen Kopplers angeordnet ist.

4. Übertragungsvorrichtung nach Anspruch 2, wobei die Detektionsschaltung (220) ferner Folgendes umfasst: einen ersten Sicherheitskondensator und einen zweiten Sicherheitskondensator; wobei
der erste Sicherheitskondensator in Reihe zwischen dem Neutralleiter und der Anode der ersten Diode geschaltet ist und der zweite Sicherheitskondensator in Reihe zwischen dem stromführenden Leiter und der Anode der zweiten Diode geschaltet ist.

5. Übertragungsvorrichtung nach Anspruch 2, wobei die Detektionsschaltung (220) ferner eine Schutzschaltung umfasst und die Schutzschaltung in Reihe zwischen dem stromführenden Leiter und dem Neutralleiter geschaltet ist; wobei
die Schutzschaltung durch eine Transient-Suppressor-Diode gebildet ist.

6. Datenübertragungsverfahren, wobei das Verfahren Folgendes umfasst:
Detektieren, durch eine Detektionsschaltung (220), eines Erdungsleiters in einem Leistungsnetz;
Empfangen, durch einen Prozessor (210), eines Detektionssignals, das durch die Detektionsschaltung (220) zurückgemeldet wird;
Bestimmen, durch den Prozessor (210) basierend auf dem Detektionssignal, ob das Leistungsnetz den Erdungsleiter umfasst;
Steuern, durch den Prozessor (210) basierend auf einem Bestimmungsergebnis, eines Schalters (230), um mit dem Erdungsleiter, einem stromführenden Leiter oder einem Neutralleiter in dem Leistungsnetz verbunden zu sein; und
Durchführen, durch den Prozessor (210), einer Datenübertragung mit einer zugehörigen Übertragungsvorrichtung, wobei die zugehörige Übertragungsvorrichtung durch den Prozessor (210) durch Steuern einer Anpassungsschaltung (240) erlangt wird, um die Anpassung durchzuführen, nachdem der Schalter (230) mit dem Erdungsleiter, dem stromführenden Leiter oder dem Neutralleiter verbunden wurde.

7. Datenübertragungsverfahren nach Anspruch 6, wobei das Verfahren vor dem Detektieren, durch eine Detektionsschaltung (220), eines Erdungsleiters in einem Leistungsnetz ferner Folgendes umfasst:
Senden, durch den Prozessor (210), einer Detektionsanweisung an die Detektionsschaltung (220) der Übertragungsvorrichtung, sodass die Detektionsschaltung (220) den Erdungsleiter in dem Leistungsnetz basierend auf der Detektionsanweisung detektiert, um zu bestimmen, ob der Erdungsleiter in dem Leistungsnetz angeordnet ist.

8. Datenübertragungsverfahren nach Anspruch 7, wobei das Detektieren, durch eine Detektionsschaltung (220), eines Erdungsleiters in einem Leistungsnetz Folgendes umfasst:
Leiten und Emittieren von Licht, durch einen Lichtemitter eines zweiten optischen Kopplers in der Detektionsschaltung (220), basierend auf der Detektionsanweisung, sodass das emittierte Licht einen Lichtempfänger des zweiten optischen Kopplers bestrahlt; und
falls der Lichtempfänger des zweiten optischen Kopplers mit dem Erdungsleiter des Leistungsnetzes verbunden ist, werden der Lichtempfänger des zweiten optischen Kopplers und ein Lichtemitter eines ersten optischen Kopplers geleitet, sodass der Lichtemitter des ersten optischen Kopplers Licht emittiert, um einen Lichtempfänger des ersten optischen Kopplers zu bestrahlen, wobei der Lichtempfänger des ersten optischen Kopplers geleitet wird und
ein Potential eines ersten Anschlusses eines Pull-up-Widerstands in der Detektionsschaltung (220) abnimmt.

9. Datenübertragungsverfahren nach einem der Ansprüche 6 bis 8, wobei das Steuern, durch den Prozessor (210) basierend auf einem Bestimmungsergebnis, eines Schalters (230), um mit dem Erdungsleiter, einem stromführenden Leiter oder einem Neutralleiter in dem Leistungsnetz verbunden zu sein, Folgendes umfasst:
falls das Leistungsnetz den Erdungsleiter umfasst, Steuern, durch den Prozessor (210), des Schalters (230), um mit dem Erdungsleiter verbunden zu sein; oder
falls das Leistungsnetz den Erdungsleiter nicht umfasst, Steuern, durch den Prozessor (210), des Schalters (230), um mit dem stromführenden Leiter oder dem Neutralleiter verbunden zu sein.

## Revendications

1. Dispositif de transmission comprenant : un processeur (210), un circuit de détection (220), un commutateur (230), un circuit d'adaptation (240) et un transformateur (250), dans lequel une première borne d'entrée du processeur (210) est connectée à une première borne de sortie du circuit de détection (220), une deuxième borne d'entrée et une troisième borne d'entrée du processeur (210) sont respectivement connectées à une première borne de sortie et à une seconde borne de sortie du circuit d'adaptation (240), et une borne de sortie du processeur (210) est connectée à une première borne du commutateur (230) ;
une première borne de sortie et une seconde borne de sortie du transformateur (250) sont respectivement connectées à une première borne d'entrée et à une deuxième borne d'entrée du circuit d'adaptation (240), une deuxième borne d'entrée du transformateur (250) est connectée à une deuxième borne du commutateur (230), et une seconde borne de sortie du circuit de détection (220) est connectée à un fil de terre ;
si une première borne d'entrée du circuit de détection (220) est connectée à un fil neutre, une deuxième borne d'entrée du circuit de détection (220) est connectée à un fil de phase, une troisième borne du commutateur (230) est connectée au fil de terre ou au fil de phase, et une première borne d'entrée du transformateur (250) est connectée au fil neutre ;
si la première borne d'entrée du circuit de détection (220) est connectée au fil de phase, la deuxième borne d'entrée du circuit de détection (220) est connectée au fil neutre, la troisième borne du commutateur (230) est connectée au fil de terre ou au fil neutre, et la première borne d'entrée du transformateur (250) est connectée au fil de phase ;
le processeur (210) est configuré pour commander le circuit de détection (220) afin de détecter le fil de terre dans un réseau électrique et déterminer, sur la base d'un signal émis par le circuit de détection (220), si le fil de terre est présent dans le réseau électrique ; si le fil de terre n'est pas présent dans le réseau électrique, la commande, par le processeur (210), du commutateur (230) à connecter au fil de phase ou au fil neutre du réseau électrique ; ou si le fil de terre est présent dans le réseau électrique, la commande, par le processeur (210), du commutateur (230) à connecter au fil de terre ; et
le transformateur (250) est configuré pour convertir l'électricité haute tension du réseau électrique en électricité basse tension, et le circuit d'adaptation (240) est configuré pour adapter le dispositif de transmission à un autre dispositif de transmission connecté au réseau électrique.

2. Dispositif de transmission selon la revendication 1, dans lequel le circuit de détection (220) comprend : un premier coupleur optique, un second coupleur optique, une résistance de rappel, une première diode et une seconde diode, dans lequel le premier coupleur optique et le second coupleur optique comprennent chacun un émetteur de lumière et un récepteur de lumière ; dans lequel
une anode de la première diode est connectée au fil neutre, et une cathode de la première diode est connectée à une borne d'entrée de l'émetteur de lumière du premier coupleur optique ; une anode de la seconde diode est connectée au fil de phase, et une cathode de la seconde diode est connectée à la borne d'entrée de l'émetteur de lumière du premier coupleur optique ; une borne de sortie de l'émetteur de lumière du premier coupleur optique est connectée à une borne d'entrée du récepteur de lumière du second coupleur optique, une borne d'entrée du récepteur de lumière du premier coupleur optique est connectée à une première borne de la résistance de rappel, et une borne de sortie du récepteur de lumière du premier coupleur optique est connectée à une borne commune ;
la première borne de la résistance de rappel est connectée à la première borne d'entrée du processeur (210), et une deuxième borne de la résistance de rappel est connectée à une alimentation haute tension ; et
une borne de sortie du récepteur de lumière du second coupleur optique est connectée au fil de terre du réseau électrique, une borne d'entrée de l'émetteur de lumière du second coupleur optique est connectée à la borne de sortie du processeur (210), et une borne de sortie de l'émetteur de lumière du second coupleur optique est connectée à la borne commune.

3. Dispositif de transmission selon la revendication 2, dans lequel le circuit de détection (220) comprend également : une première résistance de limitation de courant et une seconde résistance de limitation de courant ; dans lequel
la première résistance de limitation de courant est disposée entre la première diode et la borne d'entrée de l'émetteur de lumière du premier coupleur optique, et la seconde résistance de limitation de courant est disposée entre la seconde diode et la borne d'entrée de l'émetteur de lumière du premier coupleur optique.

4. Dispositif de transmission selon la revendication 2, dans lequel le circuit de détection (220) comprend également : un premier condensateur de sécurité et un second condensateur de sécurité ; dans lequel
le premier condensateur de sécurité est connecté en série entre le fil neutre et l'anode de la première diode, et le second condensateur de sécurité est connecté en série entre le fil de phase et l'anode de la seconde diode.

5. Dispositif de transmission selon la revendication 2, dans lequel le circuit de détection (220) comprend également un circuit de protection, et le circuit de protection est connecté en série entre le fil de phase et le fil neutre ; dans lequel le circuit de protection est constitué d'une diode de suppression des transitoires.

6. Procédé de transmission de données, dans lequel le procédé comprend :
la détection, par un circuit de détection (220), d'un fil de terre dans un réseau électrique ;
la réception, par un processeur (210), d'un signal de détection renvoyé par le circuit de détection (220) ;
le fait de déterminer, par le processeur (210) sur la base du signal de détection, si le réseau électrique comprend le fil de terre ;
la commande, par le processeur (210) sur la base d'un résultat de détermination, d'un commutateur (230) à connecter au fil de terre, à un fil de phase ou à un fil neutre du réseau électrique : et
la réalisation, par le processeur (210), d'une transmission de données avec un dispositif de transmission apparié, dans lequel le dispositif de transmission apparié est obtenu par le processeur (210) en commandant un circuit d'adaptation (240) pour réaliser une adaptation après que le commutateur (230) soit connecté au fil de terre, au fil de phase ou au fil neutre.

7. Procédé de transmission de données selon la revendication 6, dans lequel, avant la détection, par un circuit de détection (220), d'un fil de terre dans un réseau électrique, le procédé comprend également :
l'envoi, par le processeur (210), d'une instruction de détection au circuit de détection (220) du dispositif de transmission, de sorte que le circuit de détection (220) détecte le fil de terre dans le réseau électrique sur la base de l'instruction de détection pour déterminer si le fil de terre est présent dans le réseau électrique.

8. Procédé de transmission de données selon la revendication 7, dans lequel la détection, par un circuit de détection (220), d'un fil de terre dans un réseau électrique comprend :
la conduite et l'émission de lumière, par un émetteur de lumière d'un second coupleur optique dans le circuit de détection (220), sur la base de l'instruction de détection, de sorte que la lumière émise irradie un récepteur de lumière du second coupleur optique ; et
si le récepteur de lumière du second coupleur optique est connecté au fil de terre du réseau électrique, le récepteur de lumière du second coupleur optique et un émetteur de lumière d'un premier coupleur optique sont conduits, de sorte que l'émetteur de lumière du premier coupleur optique émet de la lumière pour irradier un récepteur de lumière du premier coupleur optique, le récepteur de lumière du premier coupleur optique est conduit et le potentiel d'une première borne d'une résistance de rappel dans le circuit de détection (220) diminue.

9. Procédé de transmission de données selon l'une quelconque des revendications 6 à 8, dans lequel la commande, par le processeur (210) sur la base d'un résultat de détermination, d'un commutateur (230) à connecter au fil de terre, à un fil de phase ou à un fil neutre du réseau électrique comprend :
si le réseau électrique comprend le fil de terre, la commande, par le processeur (210), de l'interrupteur (230) à connecter au fil de terre ; ou
si le réseau électrique ne comprend pas le fil de terre, la commande, par le processeur (210), de l'interrupteur (230) à connecter au fil de phase ou au fil neutre.
